# EUROPÄISCHE PATENTSCHRIFT

(11) **EP 2 052 264 B1**
(45) Veröffentlichungstag und Bekanntmachung des Hinweises auf die Patenterteilung: **11.09.2013**
(21) Anmeldenummer: 07786100.3
(22) Anmeldetag: 16.07.2007
(51) Int. Cl.: G01R 1/067, G01R 1/30

(54) **OSZILLOSKOP-TASTKOPF**
OSCILLOSCOPE PROBE
SONDE D'OSCILLOSCOPE

(30) Priorität: 14.08.2006 DE 102006038028; 08.11.2006 DE 102006052720
(43) Veröffentlichungstag der Anmeldung: 29.04.2009
(73) Patentinhaber: Rohde & Schwarz GmbH & Co. KG, 81671 München (DE)
(72) Erfinder: PESCHKE, Martin, 81549 München (DE); SCHILD, Alexander, 85622 Feldkirchen (DE)
(74) Vertreter: Körfer, Thomas
(86) Internationale Anmeldenummer: PCT/EP2007/006298
(87) Internationale Veröffentlichungsnummer: WO 2008/019740

(56) Entgegenhaltungen:
- US-A- 4 803 423
- US-A- 5 602 483
- US-A- 5 654 669
- US-B1- 6 870 359

## Beschreibung

Die Erfindung betrifft einen Tastkopf für ein Oszilloskop laut Oberbegriff des Hauptanspruches.

Bei aktiven Tastköpfen für Oszilloskope, mit denen massebezogene Signale gemessen werden, ist die das zu messende Signal hochohmig abgreifende Messspitze mit einem als Impedanzwandler dienenden Verstärker verbunden, dessen Ausgang eine charakteristische Impedanz von meist 50 Ohm besitzt. Das Messsignal wird vom Ausgang dieses Verstärkers über ein HF-Kabel dem Eingang des Oszilloskops zugeführt, der das Kabel mit seiner charakteristischen Impedanz von beispielsweise 50 Ohm abschließt, um so Reflexionen zu vermeiden.

Solche Verstärker weisen für gewöhnlich einen sog. Gleichspannungs-Offset-Fehler auf, d.h. eine Eingangsspannung von 0 Volt entspricht nicht exakt einer Ausgangsspannung von 0 Volt. Um diesen Fehler möglichst gering zu halten, ist es bekannt, aufwendige Verstärkertopologien zu verwenden. So ist es beispielsweise aus der US-Patentschrift 5, 384, 532 oder 5,602,433 bekannt, bei einem massebezogenen Tastkopf großer Bandbreite einen Verstärker als Impedanzwandler einzusetzen, der als Composite-Verstärker, bestehend aus einem Hochfrequenz-Pfad für hohe Frequenzen und einem Niederfrequenz-Pfad für tiefe Frequenzen und Gleichspannungen, aufgebaut ist. Der Verstärker im Niederfrequenz-Pfad ist hier ein Operationsverstärker mit möglichst geringem Offset. Der Hochfrequenz-Pfad für hohe Frequenzen von beispielsweise über 10 MHz besteht aus einem dreistufigen Emitterfolger mit Transistoren vom npn-Typ und ist als wechselstrom-gekoppelter Verstärker mit einem zwischen Messspitze und Verstärkereingang angeordneten Trennkondensator ausgebildet.

Auch diese bekannte Anordnung besitzt verschiedene Nachteile. So sind beispielsweise Übernahmeverzerrungen bei Frequenzen zu befürchten, die über beide Pfade zum Ausgang gelangen. Bezüglich des Operationsverstärkers muss ein Kompromiss zwischen der Bandbreite des Niederfrequenz-Pfades, der Eingangskapazität und einem möglichst niedrigem Offset getroffen werden, was in der Praxis schwierig ist. Außerdem verschlechtern der Eingangswiderstand, die Eingangskapazität und der Eingangsstrom des Niederfrequenz-Pfades die Kenndaten des Tastkopfes.

Es ist die Aufgabe der Erfindung, einen Oszilloskop-Tastkopf zu schaffen, dessen Verstärker einen einfachen Aufbau aufweist und trotzdem minimalen Gleichspannungs-Offset-Fehler besitzt.

Diese Aufgabe wird ausgehend von einem Tastkopf laut Oberbegriff des Hauptanspruches durch dessen kennzeichnende Merkmale gelöst. Vorteilhafte Weiterbildungen bezüglich des verwendeten Verstärkers sowie bezüglich der Kompensation eines noch verbleibenden Offset-Restfehlers ergeben sich aus den Unterancprüchen.

Gemäß der Erfindung wird im Gegensatz zum Stand der Technik ein gleichstromgekoppelter Transistorverstärker verwendet, der aus bipolaren Transistoren in Emitterfolgerschaltung, aus Feldeffekttransistoren in Sourcefolgerschaltung oder einer Kombination aus beiden aufgebaut ist. Dabei ist die verwendete Verstärkertopologie so gewählt, dass die Summe der aufeinander folgenden Offset-Gleichspannungen der einzelnen Verstärkerelemente sich aufhebt, also der Gesamtverstärker einen Offset-Fehler von praktisch 0 Volt besitzt.

Trotz dieser erfindungsgemäßen Maßnahme wird in der Praxis oftmals ein geringer Offset zwischen Verstärkereingang und Verstärkerausgang bestehen bleiben. Dieser ist jedoch klein genug, um vom Oszilloskop-Eingang toleriert zu werden. Durch geeignete Schaltungsmaßnahmen kann erreicht werden, dass der Offset unabhängig von Temperatur und Alterung der Schaltung ist. Es besteht die Möglichkeit, diesen Offset durch eine Kalibriermessung zu ermitteln und im Oszilloskop entsprechend zu berücksichtigen. Diese Kalibriermessung kann auch automatisch durchgeführt werden, indem am Eingang des Verstärkers eine Nullungsschaltung vorgesehen wird, d.h. der Verstärkereingang wird beispielsweise durch einen Schalter automatisch an Masse gelegt.

Eine weitere Möglichkeit besteht darin, den Offset parallel zum Verstärker zu messen und zu kompensieren, wobei entweder eine unmittelbare Kompensation durch Regelung im Verstärker selbst erfolgt oder indem der im Verstärker bzw. erst im Oszilloskop gemessene Offset toleriert wird und unkompensiert bleibt und erst bei der anschließenden Auswertung eines Messwertes im Oszilloskop entsprechend berücksichtigt wird.

Die Erfindung wird im Folgenden anhand schematischer Zeichnungen an Ausführungsbeispielen näher erläutert. In der Zeichnung zeigen:
- Fig. 1 - 5: mögliche Ausführungsbeispiele eines erfindungsgemäßen Gleichstrom-gekoppelten Verstärkers aufgebaut aus bipolaren Transistoren in Emitterfolgerschaltung, selbst leitenden Feldeffekttransistoren in Sourcefolgerschaltung bzw. als Mischung aus diesen beiden Schaltungsmöglichkeiten ggf. ergänzt durch Dioden oder Widerstände;
- Fig. 6 u. 7: die Möglichkeit der unmittelbaren Kompensation eines Rest-Offsets im Verstärker selbst und
- Fig. 8: eine Möglichkeit für das Messen der Offset-Spannung im Oszilloskop und deren Berücksichtigung bei der Messspannungs-Auswertung.

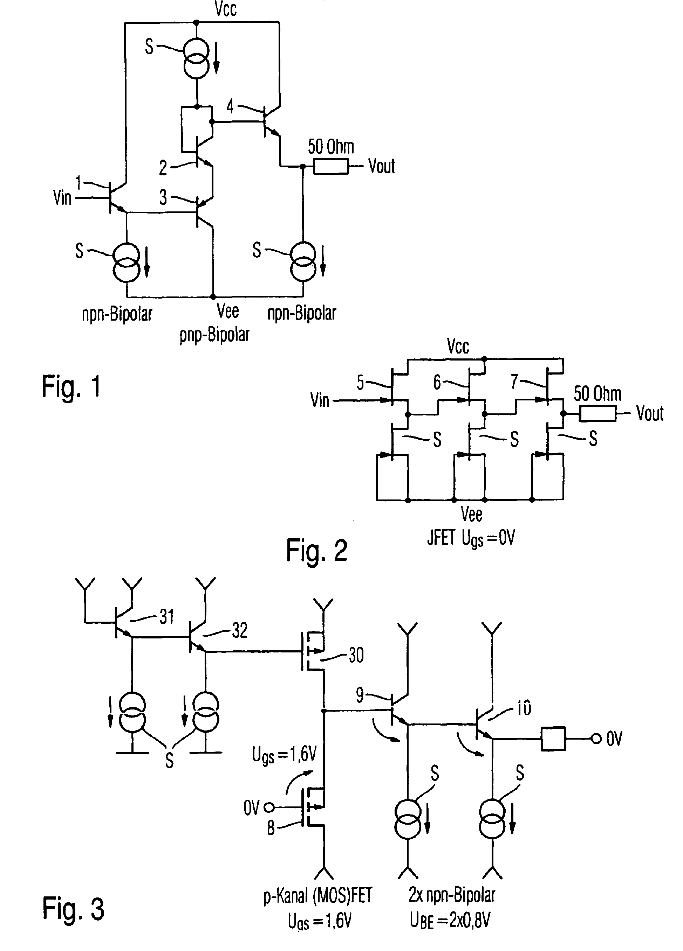

Fig. 1 zeigt einen Gleichstrom-gekoppelten Verstärker bestehend aus drei in Emitterschaltung betriebenen bipolaren Transistoren 1, 3 und 4 ergänzt durch einen vierten als Diode geschalteten bipolaren Transistor 2 zum Spannungsversatz. Der Eingangstransistor 1, dem von der Messspitze des Tastkopfes die Eingangsspannung Vᵢₙ zugeführt wird, ist vom npn-Typ, der folgende Transistor 3 ist vom pnp-Typ und der Ausgangstransistor 4 ist wieder npn-Typ. Die Einstellung der Arbeitspunkte der Transistoren erfolgt über die Stromquellen S. Die Basis-Emitter-Spannung der Transistoren 1 und 4 beträgt im Beispiel +0,8 Volt, die des Transistors 3 und die Richtspannung der Diode 2 -0,8 Volt, daraus resultiert eine Offset-Gleichspannung von etwa 0 Volt.

Bei der selbstleitenden Sourcefolgerschaltung nach Fig. 2 aufgebaut aus JFET- oder HEMT-Feldeffekttransistoren 5, 6 und 7 ist der Source-Strom so gewählt, dass die Gate-Source-Spannung U_{gs} 0 Volt ist. Dies ist z. B. durch den Einsatz von gepaarten Feldeffekttransistoren als Stromquellen S möglich, deren Gate-Source-Spannung auf 0 Volt gesetzt wird. Auch bei dieser Schaltung nach Fig. 2 wird also zwischen Eingang und Ausgang ein Offset von nahezu 0 Volt erreicht.

Fig. 3 zeigt einen DC-gekoppelten Verstärker bestehend aus einem MOSFET-Transistor 8 vom p-Kanal-Typ, der eine Gate-Source-Spannung von etwa 1,6 Volt besitzt, gefolgt von zwei in Emitterfolgerschaltung angeordneten bipolaren npn-Transistoren 9 und 10, die zusammen eine BasisEmitterspannung von -1,6 Volt besitzen. Auch hier wird also ein Offset von nahezu 0 Volt erreicht. Die Einstellung der Gate-Source-Spannung passend zu den Basis-Emitterspannungen der npn-Transistoren geschieht über einen weiteren p-Kanal MOSFET 31 als Stromquelle, dessen Gate-Source-Spannung durch zwei npn-Basis-Emitterstrecken 31, 32 festgelegt wird.

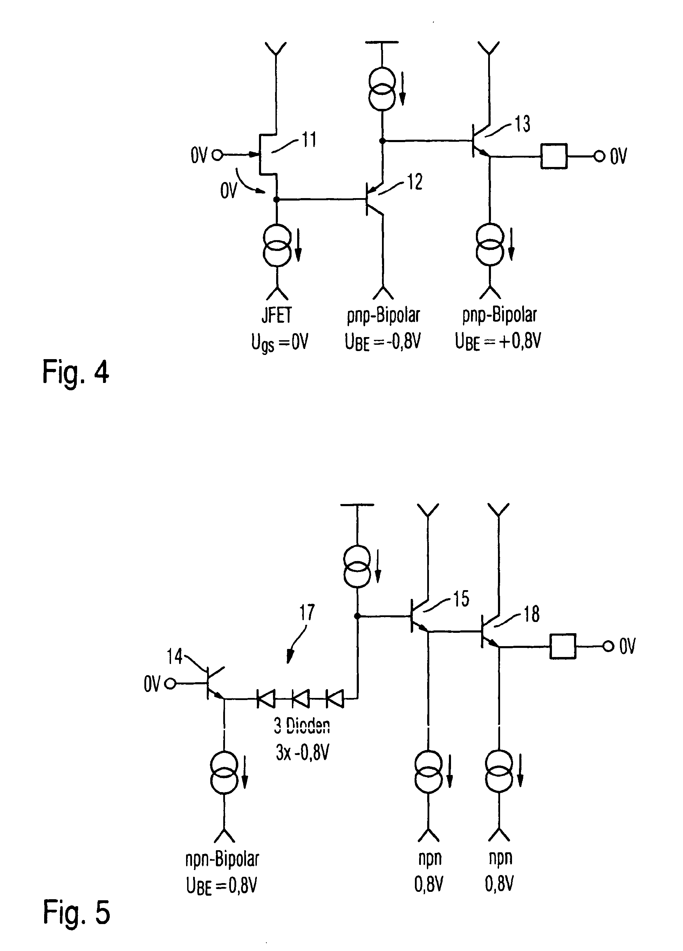

Gemäß Fig. 4 ist ein JFET-Feldeffekttransistor 11 mit zwei bipolaren Transistoren 12 und 13 jeweils von unterschiedlichem Leitungstyp zusammengeschaltet, auch hier ergibt sich in der Summe ein offset von nahezu 0 Volt.

Fig. 5 zeigt schließlich die Kombination von bipolaren Transistoren 14 bis 16 vom gleichen (npn-) Leitfähigkeitstyp mit drei Dioden 17. Die Aufeinanderfolge der Basis-Emitter-Spannungen mit den Richtspannungen der Dioden ergibt wieder einen Offset von nahezu 0 Volt.

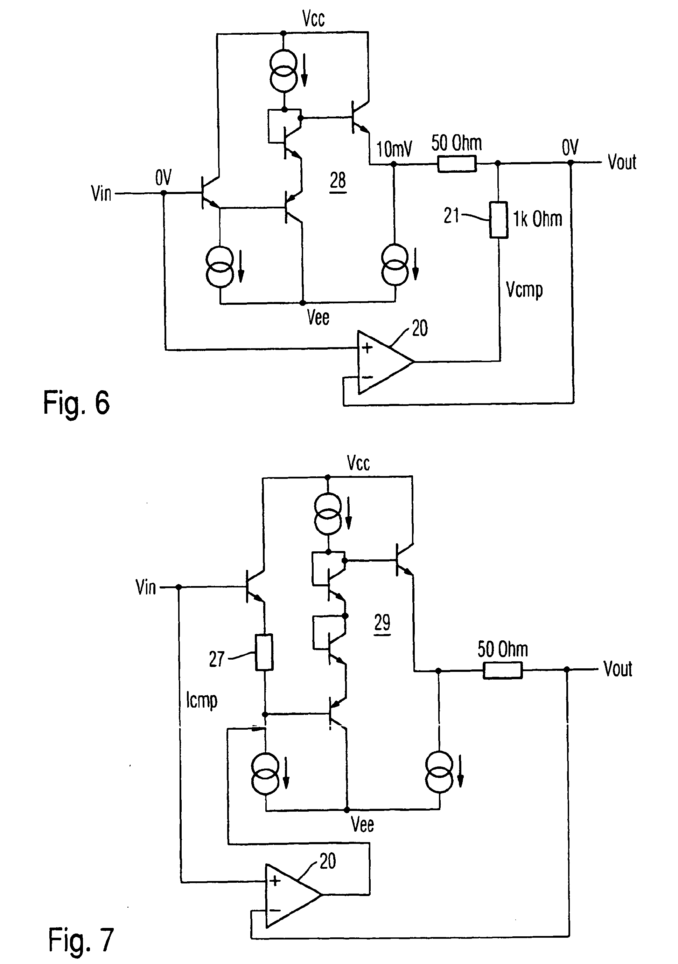

Ein evtl. noch verbleibender Offset-Rest bei diesen verschiedenen DC-gekoppelten Transistorverstärkern kann unmittelbar im Verstärker selbst gemäß Fig. 6 bzw. 7 kompensiert werden. In Fig. 6 wird dazu in einem Operationsverstärker 20 die Eingangsspannung Vᵢₙ des Verstärkers 28 mit der Ausgangsspannung Vₒᵤₜ verglichen und so ein evtl. bestehender Rest-Offset des Verstärkers 28 gemessen, der dann unmittelbar als Kompensationsspannung über einen Widerstand 21 dem Ausgang des Verstärkers 28 zugeführt wird und so den Rest-Offset kompensiert. Im Ausführungsbeispiel nach Fig. 7 wird aus dem gemessenen Offset des Verstärkers 29 ein Kompensationsstrom erzeugt, mit dem unmittelbar der Strom durch den Widerstand 27 so geregelt wird, dass der Rest-Offset des Verstärkers 29 kompensiert wird.

Vor dem Verstärker kann im Tastkopf noch ein Eingangsteiler angeordnet sein, der zwischen Messspitze und Verstärkereingang Vᵢₙ geschaltet ist. Die Messung der Offset-Spannung für die Kompensation wird in diesem Fall dann entweder vor oder nach dem Eingangsteiler als Eingangsspannung abgegriffen.

Alle Elemente des erfindungsgemäßen Tastkopfes wie Verstärker, Schaltung zur Offsetmessung, Eingangsteiler und dergleichen können als Hybrid auf einem Substrat aufgebaut werden. Der Teiler kann also beispielsweise in Dünn- oder Dickschichttechnik aufgebaut sein, der Verstärker als Bipolar-IC. Es ist auch denkbar, den Eingangsteiler mit dem Verstärker und der Schaltung zur Offsetmessung auf einem Chip monolithisch integriert aufzubauen.

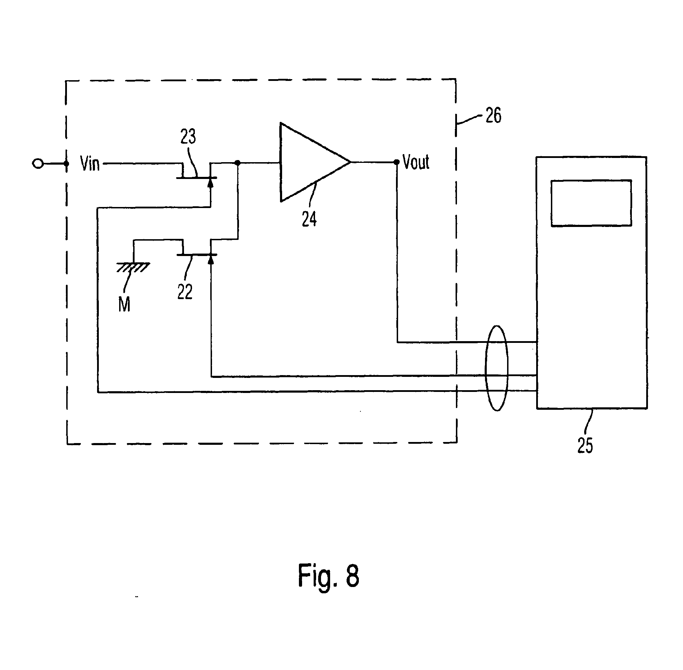

Fig. 8 zeigt eine Möglichkeit für die Messung des Offsets mittels eines vom Oszilloskop aus ferngesteuerten elektronischen Schalters 22, durch den der Eingang des DC-gekoppelten Verstärkers 24 bei über den elektronischen Schalter 23 von der Messspitze getrenntem Eingang des Verstärkers 24 an Masse M schaltbar ist, so dass im Oszilloskop 25 anstelle der Messspannung unmittelbar der Offset des Verstärkers 24 gemessen wird. Dieser Wert kann dann anschließend bei der späteren Auswertung eines Messwertes im Oszilloskop 25 berücksichtigt werden, wobei Schalter 23 wieder geschlossen und Schalter 22 offen ist. Diese Art der Messung des Offsets besitzt den zusätzlichen Vorteil, dass auch evtl. Offsets der Verstärkerschaltungen im Oszilloskop selbst mit berücksichtigt werden können, je nachdem, an welcher Stelle des insgesamt zwischen Tastkopf und Anzeigeeinrichtung des Oszilloskops wirksamen Verstärkerschaltung im Oszilloskop der Offsets gemessen wird.

Die Erfindung ist nicht auf die dargestellten Ausführungsbeispiele beschränkt.

## Patentansprüche

1. Tastkopf für ein Oszilloskop mit einem als Impedanzwandler wirkenden mehrstufigen TransistorVerstärker, dessen Ausgang mit dem Oszilloskop verbunden ist,
**dadurch gekennzeichnet,**
**dass** der Verstärker eine gleichstromgekoppelte, aus bipolaren Transistoren aufgebaute Emitterfolgerschaltung mit aufeinander folgenden Verstärkerelementen oder eine gleichstromgekoppelte, aus Feldeffekt-Transistoren aufgebaute Sourcefolgerschaltung mit aufeinander folgenden Verstärkerelementen oder eine aus diesen beiden Schaltungen zusammengesetzte Schaltung ist, deren aufeinander folgende Verstärkerelemente so dimensioniert und aufeinander abgestimmt sind, dass die Summe der aufeinander folgenden Offset-Gleichspannungen der Verstärkerelemente sich aufhebt und die resultierende Offset-Gleichspannung zwischen Eingang und Ausgang minimal ist.

2. Tastkopf nach Anspruch 1,
**dadurch gekennzeichnet,**
**dass** die Transistoren der Emitterfolger- bzw. Sourcefolger-Schaltungen mit zwischengeschalteten Dioden und/oder Widerständen so gemischt sind, dass die Offset-Gleichspannung minimal ist.

3. Tastkopf nach Anspruch 1 oder 2,
**dadurch gekennzeichnet,**
**dass** der Verstärker eine aus mehreren bipolaren Transistoren aufgebaute Emitterfolgerschaltung ist, und
die aufeinander folgenden Transistoren derart gemischt vom npn- bzw. pnp-Leitungstyp gewählt sind, dass die Summe der aufeinander folgenden Basis-Emitter-Spannungen minimal ist.

4. Tastkopf nach Anspruch 1 oder 2,
**dadurch gekennzeichnet,**
**dass** der Verstärker eine aus mehreren Feldeffekttransistoren bestehende selbstleitende Sourcefolgerschaltung ist, deren Source-Ströme so gewählt sind, dass die Gate-Source-Spannungen der einzelnen Transistoren und damit auch deren Summe nahezu 0 Volt ist.

5. Tastkopf nach Anspruch 1,
**dadurch gekennzeichnet,**
**dass** der Gleichstrom-gekoppelte Verstärker aus einer Mischung von bipolaren Transistoren und Feldeffekttransistoren und ggf. Dioden und/oder Widerständen besteht, die so dimensioniert und aufeinander abgestimmt sind, dass die Summe der aufeinander folgenden Basis-Emitter-Spannungen, Gate-Source-Spannungen und ggf. Richtspannungen der Dioden und Spannungen der Widerstände nahezu 0 Volt ist.

6. Tastkopf nach einem der vorhergehenden Ansprüche,
**dadurch gekennzeichnet,**
**dass** dem gleichstromgekoppelten Verstärker eine mit dem Eingang und Ausgang des Verstärkers verbundene Schaltung (20) zum Messen des Offsets und zum Erzeugen einer diesem entsprechenden Kompensationsgröße zugeordnet ist, mit welcher mittels einer dem Verstärker zugeordneten Kompensations-Schaltüng (20) dieser Offset unmittelbar im Verstärker kompensiert wird.

7. Tastkopf nach Anspruch 6,
**dadurch gekennzeichnet,**
**dass** der Offset mittels eines die Ein- und Ausgangsspannung des Verstärkers vergleichenden Operationsverstärkers (20) gemessen wird.

8. Tastkopf nach Anspruch 6 oder 7,
**dadurch gekennzeichnet,**
**dass** die Kompensationsgröße als Kompensationsspannung unmittelbar dem Ausgang des Verstärkers zu einer Kompensation des Offsets zugeführt wird.

9. Tastkopf nach Anspruch 6 oder 7,
**dadurch gekennzeichnet,**
**dass** die Kompensationsgröße als Kompensationsstrom dem Bias-Strom eines der aufeinander folgenden Verstärkerelemente des Verstärkers zu einer Kompensation des Offsets zugeführt wird.

10. Tastkopf nach einem der vorhergehenden Ansprüche 1 bis 5,
**dadurch gekennzeichnet,**
**dass** dem Gleichstrom-gekoppelten Verstärker eine mit dem Eingang und Ausgang des Verstärkers verbundene Schaltung zum Messen des Offsets und zum Erzeugen einer diesem entsprechenden Kompensationsgröße zugeordnet ist, die über eine zusätzliche Leitung dem Oszilloskop zur Kompensation des Offsets im Oszilloskop zur Verfügung gestellt wird.

11. Tastkopf nach Anspruch 10,
**dadurch gekennzeichnet,**
**dass** der Offset mittels eines die Ein- und Ausgangsspannung des Verstärkers vergleichenden Operationsverstärkers gemessen wird.

12. Tastkopf nach Anspruch 10 oder 11,
**dadurch gekennzeichnet,**
**dass** die gemessene Offset-Spannung dem Oszilloskop in digitaler Form zur Verfügung gestellt wird und dort bei der Auswertung der Messspannung im Oszilloskop entsprechend berücksichtigt wird.

13. Tastkopf nach einem der vorhergehenden Ansprüche,
**dadurch gekennzeichnet,**
**dass** dem Eingang des gleichstromgekoppelten Verstärkers eine über das Oszilloskop fernsteuerbare oder manuell bedienbare Schaltvorrichtung zugeordnet ist, über welche anstelle der Messspannung der Messspitze Massepotential an den Verstärkereingang anschaltbar ist und so bei an Masse liegendem Verstärkereingang der Gleichspannungs-Offset im Oszilloskop gemessen und bei der Auswertung der Messspannung im Oszilloskop entsprechend berücksichtigt wird.

14. Tastkopf nach einem der vorhergehenden Ansprüche,
**dadurch gekennzeichnet,**
**dass** dem gleichstromgekoppelten Verstärker ein Eingangs-Spannungsteiler vorgeschaltet ist.

15. Tastkopf nach Anspruch 5,
**dadurch gekennzeichnet,**
**dass** der gleichstromgekoppelte Verstärker aus einem MOSFET-Transistor (8) vom p-Kanal-Typ gefolgt von zwei in Emitterfolgerschaltung betriebenen bipolaren npn-Transistoren (9, 10) besteht.

16. Tastkopf nach Anspruch 15,
**dadurch gekennzeichnet,**
**dass** die Einstellung der Gate-Source-Spannung des MOSFET-Transistors (8) passend zu den Basis-Emitter-Spannungen der npn-Transistoren (9, 10) über einen p-Kanal-MOSFET-Transistor (30) erfolgt, dessen Gate-Source-Spannung durch zwei npn-Basis-Emitterstrecken (31 ,32) festgelegt ist.

## Claims

1. Probe for an oscilloscope with a multi-stage transistor amplifier acting as an impedance converter, of which the output is connected to the oscilloscope,
**characterised in that**
the amplifier is a DC-coupled emitter-follower circuit constructed from bipolar transistors with successive amplifier elements or a DC-coupled source-follower circuit constructed from field-effect transistors with successive amplifier elements or a circuit composed of both of these circuits, of which the successive amplifier elements are dimensioned and matched to one another in such a manner that the sum of the successive offset DC voltages of the amplifier elements is cancelled, and the resulting offset direct voltage between the input and the output is minimal.

2. Probe according to claim 1,
**characterised in that**
the transistors of the emitter-follower- and respectively source-follower-circuits are mixed with intermediate diodes and/or resistors connected in such a manner that the offset direct voltage is minimal.

3. Probe according to claim 1 or 2,
**characterised in that**
the amplifier is an emitter-follower circuit constructed from several bipolar transistors, and the successive transistors are selected from a mixture of the npn and respectively pnp conductor type in such a manner that the sum of the successive base-emitter voltages is minimal.

4. Probe according to claim 1 or 2,
**characterised in that**
the amplifier is a self-conducting source-follower circuit consisting of several field-effect transistors, of which the source currents are selected in such a manner that the gate-source voltages of the individual transistors and therefore also their sum is approximately 0 volts.

5. Probe according to claim 1,
**characterised in that**
the DC-coupled amplifier consists of a mixture of bipolar transistors and field-effect transistors and optionally diodes and/or resistors, which are dimensioned and matched to one another in such a manner that the sum of the successive base-emitter voltages, gate-source voltages and optionally rectified voltages of the diodes and voltages of the resistors is approximately 0 volts.

6. Probe according to any one of the preceding claims,
**characterised in that**
a circuit (20) connected to the input and output of the amplifier for measuring the offset and for generating a compensation value corresponding to the latter is allocated to the DC-coupled amplifier, with which compensation value this offset is compensated directly in the amplifier by means of a compensation circuit (20) allocated to the amplifier.

7. Probe according to claim 6,
**characterised in that**
the offset is measured by means of an operational amplifier (20) comparing the input voltage and output voltage of the amplifier.

8. Probe according to claim 6 or 7,
**characterised in that**
the compensation value is supplied directly to the output of the amplifier as a compensation voltage for the compensation of the offset.

9. Probe according to claim 6 or 7,
**characterised in that**
the compensation value is supplied to the bias-current of one of the successive amplifier elements of the amplifier as a compensation current for the compensation of the offset.

10. Probe according to any one of the preceding claims 1 to 5,
**characterised in that**
a circuit connected to the input and output of the amplifier for measuring the offset and for generating a compensation value corresponding to the latter is allocated to the DC-coupled amplifier, which compensation value is provided via an additional conductor to the oscilloscope for the compensation of the offset in the oscilloscope.

11. Probe according to claim 10,
**characterised in that**
the offset is measured by means of an operational amplifier comparing the input and output voltage of the amplifier.

12. Probe according to claim 10 or 11,
**characterised in that**
the measured offset voltage is provided to the oscilloscope in digital form and taken into consideration accordingly in the evaluation of the measured voltage in the oscilloscope.

13. Probe according to any one of the preceding claims,
**characterised in that**
a switching device capable of being controlled remotely or operated manually via the oscilloscope is allocated to the input of the DC-coupled amplifier, by means of which an earth potential can be connected to the amplifier input instead of the measured voltage of the probe tip, and accordingly, with the amplifier input connected to earth, the direct-voltage offset is measured in the oscilloscope and taken into consideration accordingly in the evaluation of the measured voltage in the oscilloscope.

14. Probe according to any one of the preceding claims,
**characterised in that**
an input-voltage divider is connected upstream of the DC-coupled amplifier.

15. Probe according to claim 5,
**characterised in that**
the DC-coupled amplifier consists of a MOSFET transistor (8) of the p-channel type followed by two bipolar npn transistors (9, 10) operated in an emitter-follower circuit.

16. Probe according to claim 15,
**characterised in that**
the adjustment of the gate-source voltage of the MOSFET transistor (8) is implemented to match the base-emitter voltages of the npn transistors (9, 10) via a p-channel MOSFET transistor (30), of which the gate-source voltage is specified by two npn-base-emitter paths (31, 32).

## Revendications

1. Sonde pour un oscilloscope comportant un amplificateur de transistors à plusieurs étages fonctionnant comme un transducteur d'impédance, dont la sortie est reliée à l'oscilloscope,
**caractérisée en ce que**
l'amplificateur est un circuit à émetteur asservi couplé en courant continu et constitué de transistors bipolaires avec des éléments amplificateurs successifs ou un circuit à source asservie couplé en continu et constitué de transistors à effet de champ avec des éléments amplificateurs successifs ou un circuit réalisé à partir de ces deux circuits, dont les éléments amplificateurs successifs sont dimensionnés et réglés de sorte que la somme des tensions continues de décalage des éléments amplificateurs s'annule et la tension continue de décalage résultante entre l'entrée et la sortie est minimale.

2. Sonde selon la revendication 1, **caractérisée en ce que**
les transistors des circuits à émetteur asservi ou à source asservie sont mélangés à des diodes et/ou résistances intercalées de sorte que la tension continue de décalage est minimale.

3. Sonde selon la revendication 1 ou 2, **caractérisée en ce que**
l'amplificateur est un circuit à émetteur asservi constitué par plusieurs transistors bipolaires, et les transistors successifs sont choisis parmi les types de conductivité npn ou pnp, de sorte que la somme des tensions base-émetteur successives est minimale.

4. Sonde selon la revendication 1 ou 2, **caractérisée en ce que**
l'amplificateur est un circuit à source asservie autoconducteur constitué de plusieurs transistors à effet de champ, dont les courants de source sont choisis de sorte que les tensions grille-source des différents transistors et ainsi leur somme sont presque 0 volt.

5. Sonde selon la revendication 1, **caractérisée en ce que**
l'amplificateur couplé en courant continu est constitué d'un mélange de transistors bipolaires et de transistors à effet de champ et le cas échéant de diodes et/ou de résistances, qui sont dimensionnés et réglés de sorte que la somme des tensions base-émetteur, les tensions grille-source et le cas échéant les tensions de redressement des diodes et les tensions des résistances sont presque 0 Volt.

6. Sonde selon l'une des revendications précédentes, **caractérisée en ce que**
un circuit (20) relié à une entrée et une sortie de l'amplificateur est associé à l'amplificateur couplé en courant continu pour mesurer le décalage et pour délivrer une grandeur de compensation correspondant à celui-ci, avec laquelle ce décalage est compensé immédiatement dans l'amplificateur grâce à un circuit de compensation (20) associé à l'amplificateur.

7. Sonde selon la revendication 6, **caractérisée en ce que**
le décalage est mesuré grâce à un amplificateur opérationnel (20) comparant une tension d'entrée et de sortie de l'amplificateur.

8. Sonde selon la revendication 6 ou 7, **caractérisée en ce que**
la grandeur de compensation est délivrée en tant que tension de compensation immédiatement à la sortie de l'amplificateur pour une compensation du décalage.

9. Sonde selon la revendication 6 ou 7, **caractérisée en ce que** la grandeur de compensation est délivrée en tant que courant de compensation au courant de polarisation d'un des éléments amplificateurs successifs de l'amplificateur pour une compensation du décalage.

10. Sonde selon l'une des revendications précédentes 1 à 5, **caractérisée en ce que**
un circuit relié à l'entrée et la sortie de l'amplificateur est associé à l'amplificateur couplé en courant continu pour mesurer le décalage et pour générer une grandeur de compensation correspondant à celui-ci, qui est mise à disposition dans l'oscilloscope en vue d'une compensation du décalage dans l'oscilloscope par l'intermédiaire d'une ligne supplémentaire.

11. Sonde selon la revendication 10, **caractérisée en ce que**
le décalage est mesuré grâce par un amplificateur opérationnel comparant la tension d'entrée et de sortie de l'amplificateur.

12. Sonde selon la revendication 10 ou 11, **caractérisée en ce que**
la tension de décalage mesurée est mise à disposition de l'oscilloscope sous forme numérique et est prise en compte de façon appropriée pour l'évaluation de la tension de mesure dans l'oscilloscope.

13. Sonde selon l'une des revendications précédentes, **caractérisée en ce que**
un dispositif de commutation manuel ou pouvant être télécommandé par l'intermédiaire de l'oscilloscope est associé à l'entrée de l'amplificateur couplé en courant continu, par l'intermédiaire duquel, au lieu de la tension de mesure de la pointe de mesure, un potentiel de masse peut être relié à l'entrée de l'amplificateur et le décalage en tension continue est mesuré dans l'oscilloscope à l'entrée de l'amplificateur se trouvant à la masse et est pris en considération de façon appropriée dans l'oscilloscope lors de l'évaluation de la tension de mesure.

14. Sonde selon l'une des revendications précédentes, **caractérisée en ce que**
un diviseur de tension d'entrée est monté en amont de l'amplificateur couplé en courant continu.

15. Sonde selon la revendication 5, **caractérisée en ce que**
l'amplificateur couplé en courant continu est constitué d'un transistor MOSFET (8) de type à canal p suivi par deux transistors npn bipolaires (9, 10) fonctionnant dans le circuit à émetteur asservi.

16. Sonde selon la revendication 15, **caractérisée en ce que**
le réglage de la tension grille-source du transistor MOSFET (8) correspondant aux tensions base-émetteur des transistors npn (9, 10) est effectué par l'intermédiaire d'un transistor MOSFET à canal p (30), dont la tension du grille-source est fixée par deux circuits base-émetteur npn (31, 32).
